(19) Europäisches Patentamt
European Patent Office
Office européen des brevets

(11) **EP 4 403 532 A1**

(12) **EUROPEAN PATENT APPLICATION**

(43) Date of publication:
**24.07.2024 Bulletin 2024/30**

(21) Application number: **24151454.6**

(22) Date of filing: **11.01.2024**

(51) International Patent Classification (IPC):
*C03C 17/34* (2006.01)    *C03C 15/00* (2006.01)
*G02B 1/115* (2015.01)    *G02B 5/02* (2006.01)
*H01L 33/00* (2010.01)    *C04B 37/00* (2006.01)

(52) Cooperative Patent Classification (CPC):
**C03C 17/3417; C03C 15/00; C03C 17/3452;
G02B 1/115; G02B 5/021;** C03C 2204/08;
C03C 2217/734; H01L 33/58

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.01.2023   JP 2023006919**

(71) Applicant: **Shin-Etsu Chemical Co., Ltd.
Tokyo (JP)**

(72) Inventors:
• **MATSUI, Harunobu**
  **Joetsu-shi (JP)**
• **HARADA, Daijitsu**
  **Joetsu-shi (JP)**
• **TAKEUCHI, Masaki**
  **Joetsu-shi (JP)**

(74) Representative: **Mewburn Ellis LLP
Aurora Building
Counterslip
Bristol BS1 6BX (GB)**

(54) **WINDOW MATERIAL FOR OPTICAL ELEMENT, LID FOR OPTICAL ELEMENT PACKAGE, AND OPTICAL ELEMENT PACKAGE**

(57)    A window material for an optical element, including: a synthetic quartz glass substrate having a flat plate shape and having main surfaces through which light is transmitted, at least one of the main surfaces being a rough surface; and an antireflection film formed on the at least one main surface of the synthetic quartz glass substrate, the main surface being the rough surface. The window material for an optical element of the present invention is easy in shape processing, undergoes little temporal change in a wide wavelength region and is stable over a long period of time, and has high total light transmittance of distributed light.

# FIG.1

**Description**

TECHNICAL FIELD

The present invention relates to a window material for an optical element that is suitable for sealing an optical element such as an ultraviolet LED, a lid for an optical element package including the window material for an optical element, and an optical element package sealed with the window material for an optical element, all of which are required to control light distribution properties.

BACKGROUND

In recent years, elements that emit light in an ultraviolet region such as a deep ultraviolet region have attracted attention in industrial water sterilization and household sterilization, a curing process of an ultraviolet curable resin, and the like. Among them, an ultra-violet light emitting diode (UV-LED) has attracted attention as an alternative material to an element subjected to environmental regulations, such as a mercury lamp. For example, in the UV-LED, light cannot be transmitted and extracted from an AlGaN substrate, a sapphire substrate or the like as a base material on which a layer for forming an element is to be stacked, so that the UV-LED is flip-chip mounted. Therefore, the element emits light having a light distribution angle, and does not often emit light having high directivity as in laser beam. Therefore, a method capable of controlling light distribution properties is required from the viewpoint of eliminating the illuminance unevenness of light. In addition, it is not easy to increase the output of the LED chip, and it is also required to improve the light extraction efficiency by a method other than increasing the chip output.

When the UV-LED is sealed, since a light emitting element is flip-chip mounted, a surface mount package (SMD PKG) is most preferably selected as a form of the optical element package. As a raw material of a window material for sealing the optical element, synthetic quartz glass having good transmittance of short-wavelength light is mainly selected. Additionally, in general, in the case of controlling the light distribution properties, a lens-shaped window material is often selected.

JP-A 2001-013304 (Patent Document 1) discloses a method for improving transmittance in a deep ultraviolet region, in which an antireflection film formed with a specific thin film configuration is deposited on a surface of quartz or fluorite and used.

JP-A 2013-226473 (Patent Document 2) discloses a method for inhibiting a decrease in the irradiation amount of ultraviolet light by using a film in which silica particles are two-dimensionally held for the inhibition of reflection of ultraviolet light to impart a moth-eye antireflection structure to the film.

Citation List

Patent Document 1: JP-A 2001-013304

Patent Document 2: JP-A 2013-226473

SUMMARY OF THE INVENTION

As described above, in the UV-LED, synthetic quartz glass is selected as the first candidate of the raw material of the window material in order to pass the short-wavelength ultraviolet light therethrough. However, synthetic quartz glass is known to be a difficult-to-cut material, and it is not easy from both technical and economic viewpoints to form a synthetic quartz glass substrate into a lens shape in order to control light distribution properties using synthetic quartz glass.

Although JP-A 2001-013304 (Patent Document 1) discloses a thin film configuration that forms an antireflection film, the document does not disclose a state of a substrate surface on which the film is deposited. In addition, this method employs the reflectance as an index, and is based on a theoretical result obtained mathematically using the TIS. Therefore, this method does not conform to the reality of a process in which light passes through an actual substrate. Specifically, in use as a window material for an optical element, it is necessary to consider a case where light enters perpendicularly to a substrate, that is, light enters the substrate at an incident angle of 0° by applying the boundary condition of the Schrodinger equation to the energy conservation law, but this method does not conform to actual use. Furthermore, in this method, the parallel light transmittance is considered as the transmittance, but in a light source having light distribution properties even though having high directivity, it is necessary to consider the total light transmittance. Therefore, this method does not provide reliability as for the total light transmittance and the light distribution properties in the actual use of the material as a window material for an optical element.

In the method described in JP-A 2013-226473 (Patent Document 2), a film in which silica particles are two-dimensionally held is used to form a moth-eye antireflection structure in the antireflection film. In this method, however, the structure is limited, and thus the degree of freedom in controlling the light distribution properties is low. In addition, since a polymer film is used, long-term reliability is low due to deterioration of a resin caused by ultraviolet light.

The present invention has been made in view of the above-mentioned circumstances, and an object of the present invention is to provide a window material for an optical element, which is used in an optical element package having an optical element that operates in an ultraviolet region, particularly in a deep ultraviolet wavelength region, which is easy in shape processing, which undergoes little temporal change in a wide wavelength region and is stable over a long period of time, and which has high total light transmittance of distributed light, a lid for an optical element package including the window material for an optical element, and an optical element package sealed with the window material for an optical element.

As a result of intensive studies to achieve the above-mentioned object, the present inventors have found the following matter and have completed the present invention. Specifically, a window material for an optical element includes a synthetic quartz glass substrate having a flat plate shape and having main surfaces through which light is transmitted, at least one of the main surfaces being a rough surface, and an antireflection film, in particular, an antireflection film formed on the at least one main surface of the synthetic quartz glass substrate, and including three layers of a first layer, a second layer, and a third layer in this order from a side of the synthetic quartz glass substrate, the layers being formed of a thin film containing $Al_2O_3$, a thin film containing $HfO_2$, and a thin film containing $MgF_2$ or $SiO_2$, respectively. Such a window material for an optical element is easy in shape processing, undergoes little temporal change in a wide wavelength region and is stable over a long period of time, has high total light transmittance of distributed light, and is excellent as a window material for an optical element used in an optical element package having an optical element that operates in an ultraviolet region, particularly in a deep ultraviolet wavelength region.

Therefore, the present invention provides the following window material for an optical element, lid for an optical element package, and optical element package.

1. A window material for an optical element, including: a synthetic quartz glass substrate having a flat plate shape and having main surfaces through which light is transmitted, at least one of the main surfaces being a rough surface; and an antireflection film formed on the at least one main surface of the synthetic quartz glass substrate, the main surface being the rough surface.

2. The window material for an optical element according to item 1, wherein in the at least one main surface as the rough surface, a total value of a dale void volume (Vvv) of a scale-limited surface having an areal material ratio of 10% and a peak material volume (Vmp) of a scale-limited surface having an areal material ratio of 80% is $1.7 \times 10^4$ $\mu m^3$ or more, the areal material ratios defined according to JIS B 0681-2: 2018.

3. The window material for an optical element according to item 1, wherein the at least one main surface as the rough surface has a surface roughness (Ra) of 0.1 to 0.5 $\mu m$, the surface roughness (Ra) being a surface roughness along an arbitrary straight line of 4 mm defined on the main surface as the rough surface.

4. The window material for an optical element according to item 1, which is a window material for a light emitting element, the light emitting element being an ultraviolet LED element that emits light having a wavelength of 255 to 300 nm.

5. The window material for an optical element according to item 4, wherein the antireflection film is formed of a metal compound selected from a metal oxide and a metal fluoride.

6. The window material for an optical element according to item 4, wherein the antireflection film includes three layers of a first layer, a second layer, and a third layer in this order from a side of the synthetic quartz glass substrate.

7. The window material for an optical element according to item 6, wherein the first layer is formed of a thin film containing $Al_2O_3$, the second layer is formed of a thin film containing $HfO_2$, and the third layer is formed of a thin film containing $MgF_2$ or $SiO_2$.

8. The window material for an optical element according to item 6, wherein optical film thicknesses of the first layer, the second layer, and the third layer of the antireflection film are in a range mentioned below relative to a central emission wavelength of the light emitting element:

$$0.20\lambda \le n_1d_1 \le 0.30\lambda,$$

$$0.45\lambda \le n_2d_2 \le 0.55\lambda,$$

and

$$0.20\lambda \le n_3d_3 \le 0.30\lambda$$

wherein $n_1$, $n_2$, and $n_3$ respectively represent refractive indices of the first layer, the second layer, and the third layer, $d_1$, $d_2$, and $d_3$ respectively represent physical film thicknesses of the first layer, the second layer, and the third layer, $n_1d_1$, $n_2d_2$, and $n_3d_3$ respectively represent the optical film thicknesses of the first layer, the second layer, and the third layer, and $\lambda$ represents the central emission wavelength of the light emitting element.

9. The window material for an optical element according to item 1, which is a window material for a light emitting element, wherein the light emitting element emits light having a light distribution angle of 150 degrees or less.

10. A lid for an optical element package, including: the window material for an optical element according to any one of items 1 to 9; and an adhesive agent layer laminated on a part of one of the main surfaces of the synthetic quartz glass substrate of the window material for an optical element.

11. The lid for an optical element package according to item 10, wherein an adhesive agent that constitutes the adhesive agent layer is a resin-based adhesive agent or a metal-based adhesive agent.

12. The lid for an optical element package according to item 10, wherein the adhesive agent layer is in a semi-cured state (B-stage).

13. An optical element package including: an optical element; a housing member in which the optical element is installed; the window material for an optical element according to any one of items 1 to 8; and an adhesive layer, wherein

the window material for an optical element is provided at a position through which the light passes; and the optical element is housed in the housing member, and the housing member and the window material for an optical element are joined to each other with the adhesive layer interposed therebetween to seal the optical element.

14. The optical element package according to item 13, wherein the optical element is a light emitting element, and the light emitting element is an ultraviolet LED element that emits light having a wavelength of 255 to 300 nm.

15. The optical element package according to item 13, wherein the optical element is a light emitting element, and the light emitting element emits light having a light distribution angle of 150 degrees or less.

## ADVANTAGEOUS EFFECTS

The window material for an optical element of the present invention is easy in shape processing, undergoes little temporal change in a wide wavelength region and is stable over a long period of time, is capable of being controlled in the light distribution properties, and has high total light transmittance of light. The window material for an optical element of the present invention is excellent as a window material for an optical element used in an optical element package having an optical element that operates in an ultraviolet region, particularly in a deep ultraviolet wavelength region, and provides high reliability to an optical element package housing an optical element that operates in an ultraviolet region, particularly in a deep ultraviolet wavelength region.

## BRIEF DESCRIPTION OF THE DRAWINGS

FIG. 1 is a cross-sectional view showing an example of a window material for an optical element of the present invention;
FIG. 2 is a cross-sectional view showing another example of the window material for an optical element of the present invention;
FIG. 3 is a cross-sectional view showing an example of an optical element package of the present invention;
FIG. 4 is an explanatory diagram of a method for evaluating a light distribution angle in Examples 1 to 5 and Comparative Examples 1 to 3;
FIG. 5 is an explanatory diagram of a method for evaluating a light distribution angle in Reference Example 1;
FIG. 6 is an explanatory diagram of a method for evaluating a light distribution angle in Examples 6 and 7; and
FIG. 7 is a diagram showing light distribution properties of optical element packages obtained in Example 1, Comparative Example 1, and Reference Example 1.

## FURTHER EXPLANATIONS; OPTIONS AND PREFERENCES

Hereinafter, the present invention is described in more detail.

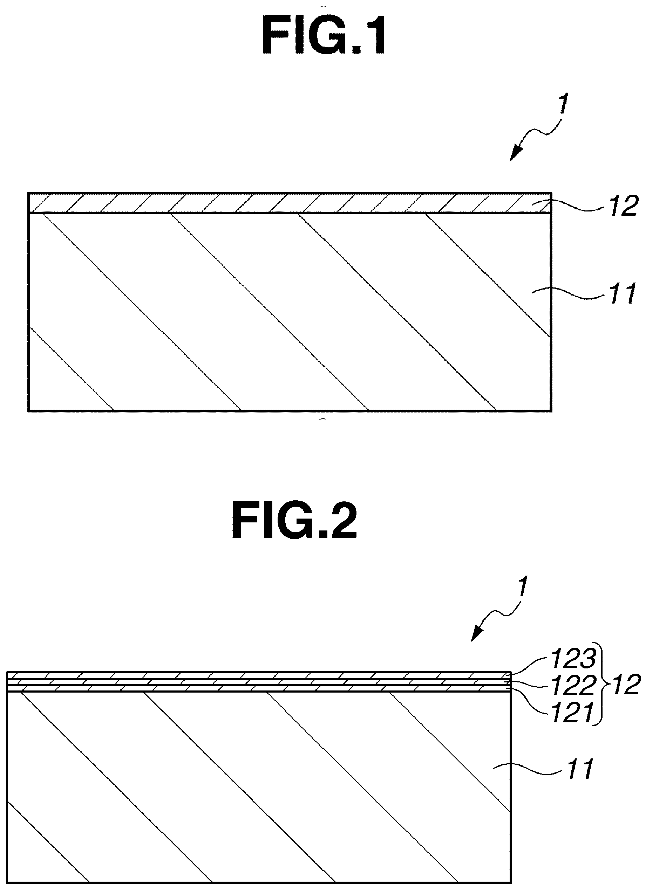

A window material for an optical element of the present invention includes a synthetic quartz glass substrate and an antireflection film. FIG. 1 is a cross-sectional view showing an example of a window material for an optical element of the present invention. A window material 1 for an optical element includes a synthetic quartz glass substrate 11 and an antireflection film 12, which is formed on an entire main surface of the synthetic quartz glass substrate 11 and in contact with the main surface.

Optical element

The optical element may be a light emitting element or a light receiving element, but is preferably a light emitting element. The window material for an optical element of the present invention can be suitably used in an optical element capable of emitting or receiving light having a wavelength of 220 nm or more, and can be suitably used in an ultraviolet LED element (UV-LED) that emits light at a wavelength of 255 to 300 nm, particularly at a central emission wavelength of 260 to 300 nm, in particular, a deep ultraviolet LED element (UVC-LED). Examples of the light emitting element include UV-LEDs based on aluminum gallium nitride (AlGaN) or sapphire ($Al_2O_3$), particularly UVC-LEDs, and a surface-emitting element is suitable.

Synthetic quartz glass substrate

The size and thickness of the synthetic quartz glass substrate can be appropriately selected in consideration of the size of the housing member, the mechanical strength of the window material for an optical element or the optical element package, and the like as long as the synthetic quartz glass substrate has a flat plate shape that is easy in shape processing. The size of the synthetic quartz glass substrate is preferably $2.0 \times 2.0$ mm or more, more preferably $3.5 \times 3.5$ mm or more, and preferably $8.0 \times 8.0$ mm or less, more preferably $6.5 \times 6.5$ mm or less in the case of an optical element package in which an optical element is flip-chip mounted. In addition, the thickness of the synthetic quartz glass substrate can be appropriately selected in consideration of the attenuation of the wavelength of light and the pressure difference from the outside of the window material for an optical element, that is, the outside of the optical element package. The thickness of the synthetic quartz glass substrate is preferably 0.1 mm or more, more preferably 0.2 mm or more, and preferably 3 mm or less, more preferably 2 mm or less. Note that the synthetic quartz glass substrate can be obtained, for example, by dicing and cutting a wafer substrate having a size of 6 inches or 8 inches and having an adjusted surface.

In the synthetic quartz glass substrate, in the at least one main surface as the rough surface, a total value of a dale void volume (Vvv) of a scale-limited surface having an areal material ratio of 10% and a peak material volume (Vmp) of a scale-limited surface having an areal material ratio of 80% is preferably $1.7 \times 10^4$ $\mu m^3$ or more, the areal material ratios defined according to JIS B 0681-2: 2018. If Vvv + Vmp is $1.7 \times 10^4$ $\mu m^3$ or more, irregularities of the main surface as the rough surface are small. Therefore, the amount of light scattered on the main surface as the rough surface is large, and the amount of light passing through the window material for an optical element as linear light is small. Thus, light distribution properties for light having a light distribution angle can be effectively changed, a light collecting type radiation flux such as Lambert reflection can be easily obtained, and light passing through the window material for an optical element can be effectively collected. The values of Vvv and Vmp can be obtained by measuring the main surface as the rough surface with a three-dimensional surface shape measuring machine.

In the synthetic quartz glass substrate, at least one of the main surfaces through which light is transmitted is a rough surface in order to scatter incident light on a surface of the substrate. It is preferable that the at least one main surface as the rough surface have a surface roughness (Ra) of 0.1 to 0.5 $\mu m$, the surface roughness (Ra) being a surface roughness along an arbitrary straight line of 4 mm defined on the main surface as the rough surface. The surface roughness (Ra) is more preferably 0.4 $\mu m$ or less. It is more preferable that the surface roughness (Ra) be in the above-mentioned range regardless of at which position on the main surface as the rough surface the straight line of 4 mm is defined. In addition, the surface roughness (Ra) can be measured in the state of the wafer substrate before the synthetic quartz glass substrate is obtained by dicing cutting. If the surface roughness (Ra) is in such a range, it is possible to reduce a defect that light becoming stray light is generated due to an increase in a reflection loss on the surface of the substrate, and to reduce a possibility that light cannot be sufficiently collected due to a decrease in light reflected on the surface of the substrate and an increase in the ratio of parallel light transmitted through the window material as it is. Note that a surface having a surface roughness (Ra) of 0.5 nm or less as measured with an atomic force microscope (AFM) or the like is usually defined as a mirror surface. A surface having a surface roughness (Ra) in such a range is a smooth surface on which light is not diffusely reflected, and can be visually recognized as a mirror surface when viewed with human eyes.

A synthetic quartz glass substrate having both the main surfaces as rough surfaces can be manufactured by molding, annealing, slicing, chamfering, or lapping a synthetic quartz glass ingot. Since the surfaces processed by lapping are rough surfaces, the synthetic quartz glass substrate obtained at this stage can be used as a synthetic quartz glass substrate having both the main surfaces as rough surfaces. Meanwhile, in the case of manufacturing a synthetic quartz glass substrate having one of the main surfaces as a rough surface, it is possible to polish one of the main surfaces of the synthetic quartz glass substrate having both the main surfaces as rough surfaces to obtain a surface that is not a rough surface (for example, a mirror surface), and it is also possible to polish both the main surfaces of the synthetic quartz glass substrate to obtain surfaces that are not rough surfaces (for example, mirror surfaces), and then roughen one of the surfaces again by sandblasting. The obtained synthetic quartz glass substrate in which one of or both the main surfaces are rough surfaces is then appropriately washed.

Subjecting the obtained rough surface to etching treatment by chemical etching can adjust the surface state of the rough surface. The surface state can be adjusted by appropriately selecting the type of the etching solution and the immersion time in the etching solution. As the etching solution, hydrofluoric acid or buffered hydrofluoric acid is suitably used. The concentration of hydrogen fluoride in hydrofluoric acid or buffered hydrofluoric acid is preferably 1 wt% or more, more preferably 3 wt% or more, still more preferably 5 wt% or more, and preferably 20 wt% or less, more preferably 15 wt% or less. If the concentration of hydrogen fluoride is less than 1 wt%, since the etching rate is low, it may take a long time to obtain a target surface state, and the productivity is low. On the other hand, if the concentration of hydrogen fluoride is more than 20 wt%, since the etching rate is high, it may be difficult to precisely adjust the surface state.

In the etching treatment, the synthetic quartz glass substrate may be immersed in an etching solution, or the etching solution may be caused to flow on the synthetic quartz glass substrate. The etching treatment may be done by batch treatment or single sheet treatment. The time for the etching treatment can be appropriately selected preferably in the range of 15 minutes or more, preferably in the range of 100 minutes or less, and more preferably in the range of 80 minutes or less. If the treatment is performed for a time shorter than 15 minutes, it is necessary to use a high-concentration etching solution, and it may be difficult to adjust to the target surface state. Meanwhile, if the treatment is performed for a time longer than 100 minutes, particularly in a case where the synthetic quartz glass substrate is immersed in an etching solution, glass components dissolved from the surface may be reattached to cause a defect, and the productivity is low. After the etching treatment, the synthetic quartz glass substrate is appropriately washed and dried to give a finished synthetic quartz glass substrate.

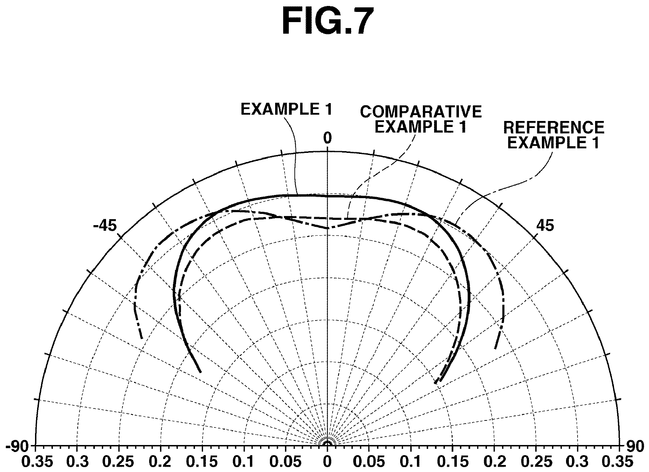

The light distribution properties of the synthetic quartz glass substrate can be evaluated using an apparatus such as a goniophotometer (for example, LEDGON manufactured by Instrument Systems, Inc.). The light distribution angle of light passing through the window material for an optical element is appropriately selected according to the application of the optical element, and the light distribution angle is generally set in the range of 30 to 100 degrees. The light distribution angle of light passing through the window material for an optical element generally varies depending on the surface state of the synthetic quartz glass substrate. In the present invention, the light distribution properties exhibited by the window material for an optical element can be controlled so that the light distribution angle of light passing through the window material for an optical element is a desired angle, and the batwing light distribution as shown by the light distribution properties of Reference Example 1 in FIG. 7 is eliminated. The batwing light distribution is characteristic of the distribution of light emitted from a surface mount optical element package in which an ultraviolet light emitting diode (UV-LED) such as a deep ultraviolet light emitting diode (UVC-LED) is flip-chip mounted, and the output right above the light emitting element is weaker than the output around the light emitting element.

In the case of arranging a plurality of optical element packages such as surface mount packages to form a module, it is required to design the module so that light emitted from the plurality of surface mount packages may enter the irradiation target without light unevenness based on the principle of superposition. If the batwing light distribution is eliminated, the design of the module can be facilitated. The batwing light distribution can be eliminated by forming the substrate into a lens shape. However, in the present invention, it is possible to eliminate the batwing light distribution by making the synthetic quartz glass substrate have a flat plate shape, not a lens shape that is technically and economically difficult to form with synthetic quartz glass. Furthermore, since the synthetic quartz glass substrate has a flat plate shape, the module can be made compact and the degree of freedom in design can be improved.

Antireflection film

An antireflection film is formed on a main surface that is a rough surface of the synthetic quartz glass substrate. Providing the antireflection film of the present invention on the main surface of the synthetic quartz glass substrate can increase the total light transmittance of light passing through the window material for an optical element. The antireflection film may be formed on the entire main surface as illustrated in FIG. 1, or may be formed only on a part of the main surface (for example, a part of the main surface excluding an outer peripheral edge part on which an adhesive agent layer of a lid for an optical element package described later is formed).

The antireflection film is preferably formed of a metal compound, and as the metal compound, a metal oxide and a metal fluoride are suitable. Examples of the metal that constitutes the metal compound include Al, Hf, Zr, Mg, and Si. In addition, the material of the antireflection film is preferably not a material that absorbs target light, particularly light having a wavelength of 255 to 300 nm.

The antireflection film of the present invention may have a single-layer structure, but preferably has a multilayer structure of two or more layers. In the case of an antireflection film having a multilayer structure, two adjacent layers have different compositions (different constituent elements or different ratios of constituent elements), but two layers that are not adjacent may have the same or different compositions.

As the antireflection film having a multilayer structure, an antireflection film including three layers of a first layer, a second layer, and a third layer in this order from the substrate side is suitable. FIG. 2 is a cross-sectional view showing another example of the window material for an optical element of the present invention. A window material 1 for an optical element includes a synthetic quartz glass substrate 11 and an antireflection film 12, which is formed on an entire main surface of the synthetic quartz glass substrate 11 and in contact with the main surface, and the antireflection film 12 includes three layers of a first layer 121, a second layer 122, and a third layer 123 from the synthetic quartz glass substrate 11 side.

In the case of an antireflection film composed of a single layer or two layers, the wavelength range in which high total light transmittance is obtained is often narrow, or wavelengths at which the total light transmittance is high are often divided into two (so-called W-shape), so that there are practical restrictions. These restrictions are particularly noticeable in the wavelength region of deep ultraviolet rays. Therefore, the antireflection film is formed to include three layers of the first layer, the second layer, and the third layer, and the second layer is provided as a layer for alleviation between the first layer and the third layer. In this case, it is possible to provide an antireflection film for which the wavelength range in which high total light transmittance is obtained is wide, the total light transmittance is not of W-shape, and high total light transmittance is stably obtained in a wide wavelength range. The antireflection film having a three-layer structure is suitable when light having a wavelength of 255 to 300 nm is targeted.

(First layer of antireflection film)

The first layer is formed on the synthetic quartz glass substrate side. Since synthetic quartz glass has a low refractive index (refractive index for light having a wavelength of 255 to 300 nm: 1.42), in order to increase the total light transmittance of light passing through the window material for an optical element by the antireflection film, it is effective that the first layer on the synthetic quartz glass substrate side is formed of a material having a refractive index higher than that of the synthetic quartz substrate, and is formed of a material having a refractive index lower than that of the second layer.

The material of the first layer is particularly preferably a metal oxide. Examples of the material of the first layer include $Al_2O_3$ (refractive index for light having a wavelength of 255 to 300 nm: 1.62), and the first layer is preferably a thin film containing $Al_2O_3$, particularly preferably a thin film made of $Al_2O_3$. Since $Al_2O_3$ is not a material that absorbs light having a wavelength of 255 to 300 nm, $Al_2O_3$ is suitable as a material of the first layer when light having a wavelength of 255 to 300 nm is targeted. In addition, the material of the first layer preferably has high adhesion to synthetic quartz glass, and is preferably less likely to form an inhomogeneous film during film formation.

(Second layer of antireflection film)

Since the second layer is an intermediate layer of the antireflection film, in order to increase the total light transmittance of light passing through the window material for an optical element by the antireflection film, it is effective that the second layer is formed of a material having a refractive index higher than that of the first layer.

The material of the second layer is particularly preferably a metal oxide. Examples of the material of the second layer include $HfO_2$ (refractive index for light having a wavelength of 255 to 300 nm: 2.20) and $ZrO_2$ (refractive index for light having a wavelength of 255 to 300 nm: 2.21), and the second layer is preferably a thin film containing $HfO_2$ or a thin film containing $ZrO_2$, particularly preferably a thin film made of $HfO_2$ and/or $ZrO_2$. Since $HfO_2$ and $ZrO_2$ are not materials that absorb light having a wavelength of 255 to 300 nm, $HfO_2$ and $ZrO_2$ are suitable as materials of the second layer when light having a wavelength of 255 to 300 nm is targeted. In addition, the material of the second layer preferably has high adhesion to the first layer and the third layer, and is preferably less likely to form an inhomogeneous film during film formation. In this respect, $HfO_2$ is excellent as the material of the second layer.

(Third layer of antireflection film)

Since the third layer is the outermost layer of the antireflection film, it is preferable that the third layer have a characteristic of reducing the reflectance, and it is effective that the third layer is formed of a low refractive index material. In addition, since the substrate is formed of synthetic quartz glass (refractive index for light having a wavelength of 255 to 300 nm: 1.42) that is a low refractive index material, the third layer that is the outermost layer is preferably formed of a material having a refractive index close to that of synthetic quartz glass.

The material of the third layer is particularly preferably a metal oxide or a metal fluoride. Examples of the material of the third layer include $MgF_2$ (refractive index for light having a wavelength of 255 to 300 nm: 1.41) and $SiO_2$ (refractive

index for light having a wavelength of 255 to 300 nm: 1.42), and the third layer is preferably a thin film containing $MgF_2$ or a thin film containing $SiO_2$, particularly preferably a thin film made of $MgF_2$ and/or $SiO_2$. Since $MgF_2$ and $SiO_2$ are not materials that absorb light having a wavelength of 255 to 300 nm, $MgF_2$ and $SiO_2$ are suitable as materials of the third layer when light having a wavelength of 255 to 300 nm is targeted. In addition, the material of the third layer preferably has high adhesion to the second layer, and is preferably less likely to form an inhomogeneous film during film formation.

$MgF_2$ can be used as a material of the third layer because when the third layer is a thin film containing $MgF_2$, even if the optical film thickness of the third layer deviates by about $\pm 0.1\lambda$ from the design value, $MgF_2$ exerts stable low refractive index characteristics, and in addition, a layer that alleviates the deviation of the optical path length is provided as the second layer. $MgF_2$ has high hygroscopicity, and for example, when left standing in the atmosphere for a long time, the film may absorb moisture in the air and may be deteriorated in the adhesion. Deterioration of the adhesion of the film reduces the transmittance because the film partially peels and air enters the peeled portion. Therefore, when the third layer is a thin film containing $MgF_2$, the window material for an optical element is preferably intended to be used in a low-humidity environment such as an inert gas environment or a dry air environment.

When the third layer is a thin film containing $SiO_2$, the reflectance is slightly higher than that in the case where the third layer is a thin film containing $MgF_2$. However, if the optical film thickness is controlled within $\pm 0.05\lambda$ from the design value, there is no problem in practical use, and the thin film containing $SiO_2$ can be used in the same manner as with the thin film containing $MgF_2$. Since $SiO_2$ is an oxide, a dense film can be formed, and the film has high moisture resistance and is hardly affected by the environment as compared with the case of $MgF_2$ that is a fluoride. Therefore, the case where the third layer is a thin film containing $SiO_2$ is advantageous when the third layer is used in a wet environment, for example, when the third layer is used in a water sterilization module or the like, which can be mentioned as an application of a UVC-LED element.

(Optical film thickness of each layer)

The antireflection film of the window material for an optical element of the present invention can have high transmittance, and in particular, can have high transmittance for light having a wavelength of 255 to 300 nm by control of the optical film thickness. In order to obtain high transmittance, there can be mentioned a method of obtaining high transmittance by laminating a plurality of very thin films that are generally called equivalent films. In this method, it is necessary to control formation of films having a physical film thickness of several nanometers, and it is not easy to laminate thin films having such a film thickness by a vacuum vapor deposition method or the like.

Considering reflection at the upper and lower interfaces of the thin film, light incident on the thin film repeats free-end reflection or fixed-end reflection at the interfaces. When the wavelength of the light is defined as $\lambda_0$, the wavelength of the light in the thin film having a refractive index of n and a physical film thickness of d is $\lambda_0/n$, and the phases of the light are theoretically aligned when the optical film thickness nd of the thin film is $0.25\lambda_0$. Therefore, it is preferable to design the antireflection film with the optical film thickness of the thin film being an integral multiple of $0.25\lambda_0$, specifically, for example, with the optical film thickness of the thin film being an integral multiple of $0.25\lambda$, where $\lambda$ represents the central emission wavelength of the light emitting element.

Meanwhile, the optical film thickness of the thin film is preferably $0.75\lambda$ or less from the viewpoint of monitoring accuracy, that is, film thickness control during formation of the antireflection film. If the optical film thickness is made larger than $0.75\lambda$, defects such as temperature unevenness are likely to occur during film formation, so that the thin film may be inhomogeneous. In addition, since an expensive metal target having high purity is used for thin film formation, an optical film thickness of the thin film closer to $0.25\lambda$ is more advantageous in terms of cost.

In a case where the antireflection film is composed of three layers of the first layer, the second layer, and the third layer in this order from the substrate side, when the refractive indices for light targeted by the first layer, the second layer, and the third layer are respectively defined as $n_1$, $n_2$, and $n_3$, and the physical film thicknesses of the first layer, the second layer, and the third layer are respectively defined as $d_1$, $d_2$, and $d_3$, the optical film thicknesses of the first layer, the second layer, and the third layer are respectively defined as $n_1d_1$, $n_2d_2$, and $n_3d_3$. From the viewpoint of throughput that depends on cost and film formation time, it is optimum that each of $n_1d_1$, $n_2d_2$, and $n_3d_3$ is close to $0.25\lambda$, and that $n_1d_1$, $n_2d_2$, and $n_3d_3$ are substantially equal.

Here, a thin film matrix M of a single layer is represented by:

$$M = \begin{bmatrix} \cos\delta & \left(\dfrac{i\,sin\delta}{n}\right) \\ in\,sin\delta & cos\delta \end{bmatrix}$$

wherein i represents the imaginary unit ($i^2 = -1$), n represents the refractive index of the thin film, and $\delta$ satisfies

$\delta = (2\pi/\lambda)nd$. Thus, in the case of a three-layer structure, the thin film matrix M is represented by:

$$M = \begin{bmatrix} 0 & i/n_1 \\ in_1 & 0 \end{bmatrix} \begin{bmatrix} 0 & i/n_2 \\ in_2 & 0 \end{bmatrix} \begin{bmatrix} 0 & i/n_3 \\ in_3 & 0 \end{bmatrix} = \begin{bmatrix} 0 & -in_2/n_1n_3 \\ -i\,n_1n_3/n_2 & 0 \end{bmatrix}$$

wherein i represents the imaginary unit ($i2 = -1$).

When considering the materials of the thin films as the first layer, the second layer, and the third layer using the thin film matrix in the case where synthetic quartz glass having a low refractive index is used as a substrate, in order to achieve the optical film thickness of $0.25\lambda$, a thin film with which the second layer has a refractive index $n_2$ for light having a wavelength of 255 to 300 nm of 1.19 is required. However, since there is no material capable of forming a thin film having a refractive index $n_2$ for light having a wavelength of 255 to 300 nm close to 1.19, an antireflection film exhibiting a high transmittance cannot be designed in the wavelength range of 255 to 300 nm on this premise.

From this result, considering the antireflection film that is not affected by the refractive index of the second layer, if only the second layer is designed to be a unit matrix, that is, the second layer is designed to satisfy $n_2d_2 = 0.5\lambda$ in the thin film matrix of a three-layer structure, the reflectance of the antireflection film is not affected by the second layer. In this case, the thin film matrix M of a three-layer structure is represented by:

$$M = \begin{bmatrix} 0 & i/n_1 \\ in_1 & 0 \end{bmatrix} \begin{bmatrix} -1 & 0 \\ 0 & -1 \end{bmatrix} \begin{bmatrix} 0 & i/n_3 \\ in_3 & 0 \end{bmatrix} = \begin{bmatrix} n_3/n_1 & 0 \\ 0 & n_1/n_3 \end{bmatrix}$$

wherein i represents the imaginary unit ($i2 = -1$). Here, the material of the second layer is required to have a higher refractive index than those of the materials of the first layer and the third layer.

If only the second layer is designed to be a unit matrix, a reflectance R of the antireflection film is determined by the values of the refractive indices of the first layer and the third layer considering the phase difference at the thin film interfaces. Therefore, in the thin film matrix of an ideal antireflection film having a reflectance of 0, the reflectance R is expressed as follows:

$$R = \frac{(n_0{n_3}^2 - n_m{n_1}^2)^2}{(n_0{n_3}^2 + n_m{n_1}^2)^2} = 0$$

wherein $n_0$ represents a refractive index of a substance in contact with the outside of the antireflection film (substance in contact with the third layer), and $n_m$ represents a refractive index of a substrate on which the antireflection film is laminated. In the present invention, assuming that light passes through the window material for an optical element and then passes into the atmosphere, the refractive index of air, that is, 1.00 can be assigned to $n_0$.

Therefore, when light having a wavelength of 255 to 300 nm is targeted, in a case where the substrate is a synthetic quartz glass substrate ($n_m = 1.42$) and the third layer is a thin film containing $SiO_2$ or $MgF_2$ ($n_3 \approx 1.42$) having a characteristic of reducing the reflectance, $n_1 \approx 1.69$, and a thin film containing $Al_2O_3$ with a stable refractive index of about 1.62 is suitable as the first layer.

In addition, in consideration of the fact that even when an ideal antireflection film having a reflectance of 0 is formed, the transmittance of light changes depending on the homogeneity of the thin films and the flatness of the interfaces, and the physical film thicknesses of the thin films are controlled on the order of nanometers, the optical film thicknesses of the thin films that constitute the antireflection film are allowed to have some deviation from $n_1d_1 = n_3d_3 = 0.25\lambda$ and $n_2d_2 = 0.50\lambda$ relative to the central emission wavelength $\lambda$. In the antireflection film of the present invention, depending on the film formation conditions and the like, it is possible to obtain a satisfactory and high total light transmittance when the optical film thicknesses of the thin films that constitute the antireflection film are within $\pm 0.05\lambda$ with respect to $n_1d_1 = n_3d_3 = 0.25\lambda$ and $n_2d_2 = 0.50\lambda$ where $n_1d_1$, $n_2d_2$, and $n_3d_3$ respectively represent the optical film thicknesses relative to the central emission wavelength $\lambda$, that is, when the optical film thicknesses are in the ranges of

$$0.20\lambda \leq n_1d_1 \leq 0.30\lambda,$$

$$0.45\lambda \leq n_2d_2 \leq 0.55\lambda,$$

and

$$0.20\lambda \leq n_3 d_3 \leq 0.30\lambda$$

wherein $\lambda$ represents the central emission wavelength of the light emitting element. In addition, it is more preferable that the optical film thicknesses of the thin films that constitute the antireflection film be in the range of $\pm 0.03\lambda$ with respect to $n_1 d_1 = n_3 d_3 = 0.25\lambda$ and $n_2 d_2 = 0.50\lambda$, which are central optical film thicknesses.

A window material for an optical element can be manufactured by forming an antireflection film (layers (thin films) that constitute the antireflection film) on a main surface that is a rough surface of a synthetic quartz glass substrate. The antireflection film may be formed on only one of or both the main surfaces as a rough surface of the synthetic quartz glass substrate. When formed on one surface, the antireflection film may be formed on the main surface on the optical element side or may be formed on the main surface on the side opposite to the optical element. The antireflection film (layers (thin films) that constitute the antireflection film) can be formed by a general thin film forming method. For example, a film can be formed using a physical vapor deposition method such as a vacuum vapor deposition method, an RF sputtering method, or an ion plating method, or a chemical vapor deposition method. From the viewpoint of film formation accuracy, it is preferable to use a vacuum vapor deposition method, and the vacuum vapor deposition method is preferably an electron beam method.

The window material for an optical element of the present invention can be suitably used particularly for light having a wavelength of 255 to 300 nm. In particular, in a case where the optical element is a light emitting element, for example, in a case where the optical element is a UV-LED assumed to be used for a long time, the light extraction efficiency can be stably improved over a long period of time. In addition, use of the window material for an optical element of the present invention for a light emitting element having a low output, such as a UVC-LED, can improve the light extraction efficiency from the light emitting element, and can also perform light distribution control.

Lid for optical element package

A lid for an optical element package of the present invention includes a window material for an optical element, and an adhesive agent layer laminated on a part of one of main surfaces of a substrate of the window material for an optical element, for example, an outer peripheral edge part of the main surface, which is a part where the window material for an optical element is in contact with a housing member.

An adhesive agent that constitutes the adhesive agent layer is not particularly limited, but is preferably a resin-based adhesive agent or a metal-based adhesive agent. The resin-based adhesive agent is formed of a resin-based paste containing a resin, has a network in the structure, and can form a three-dimensional structure. Therefore, the resin-based adhesive agent can be bonded to a synthetic quartz glass substrate, and further can be bonded to many materials such as ceramics and metals. Examples of the resin-based adhesive agent include adhesive agents of ultraviolet curing type and silicone type, and examples thereof include TB3114 (manufactured by ThreeBond Co., Ltd.) and KER-3000-M2 (manufactured by Shin-Etsu Chemical Co., Ltd.). The resin-based adhesive agent can be applied onto a synthetic quartz glass substrate by a known method.

Meanwhile, examples of the metal-based adhesive agent include low-temperature solder materials such as Au-Sn and Zn-Sn, sintered materials formed from metal nanoparticles such as nanosilver particles, and fused bodies of low-temperature solder materials and nanoparticles. As the adhesive agent containing a low-temperature solder material or a sintered material formed from nanoparticles, a commercially available product can also be used. Examples of the adhesive agent containing a fused body of a low-temperature solder material and nanoparticles include a fused body obtained by mixing at least one selected from Sn-Bi, Sn-Zn-Bi, and Sn-Zn known as a low-temperature solder material with nanosilver particles having an average primary particle diameter of 100 nm or less as a principal component, and further containing at least one metal selected from zinc, zirconium, tellurium, antimony, and indium. When the metal-based adhesive agent is used as the adhesive agent, the adhesive agent is applied onto the substrate by an application method such as a dispenser, screen printing, or inkjet printing, and the adhesive agent is in a paste form at the time of application. The applied adhesive agent layer can be brought into a semi-cured state (B-stage) through a preheating step as necessary.

Optical element package

The window material for an optical element and the lid for an optical element package of the present invention are suitably used for sealing an optical element package housing an optical element for which airtightness is required, such as a UV-LED. Use of the window material for an optical element and the lid for an optical element package of the present invention makes it possible to form an optical element package including an optical element, a housing member in which the optical element is installed, the window material for an optical element, and an adhesive layer. In this case, the window material for an optical element is provided at a position through which the light passes, and the optical element is housed in the housing member, and the housing member and the window material for an optical element are joined to each other with the adhesive layer interposed therebetween to seal the optical element. In particular, when an adhesive agent layer is formed on the window material for an optical element and the product is used as a lid for an optical element package, the adhesive agent layer of the lid for an optical element package serves as an adhesive layer that bonds the window material for an optical element to the housing member, and an optical element package in which the optical element is hermetically sealed inside the housing member can be formed.

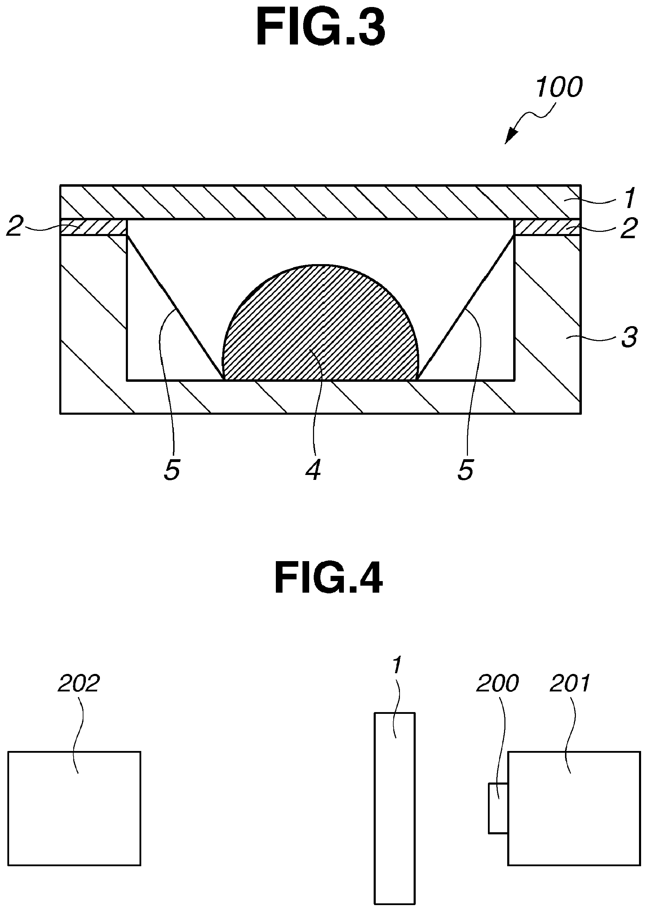

Specific examples of the optical element package of the present invention include a surface mount optical element package 100 as illustrated in FIG. 3. In the surface mount optical element package 100, an optical element 4 such as an LED chip is hermetically sealed by an adhesive layer 2, which is formed of the cured adhesive agent layer and is provided between the window material 1 for an optical element and a housing member 3 housing the optical element 4. In FIG. 3, a reflective plate 5 is provided.

As the housing member, a member known as a member for housing an optical element in the optical element package can be used, and a member formed of an inorganic material such as a metal or ceramic, or an organic material such as a rubber, an elastomer, or a resin, and having a recessed part as a housing part for the optical element is used. The size of the housing member is appropriately selected according to the application of the optical element, the size of the optical element to be housed, the size of the window material for an optical element, and the like. In particular, when the optical element is an LED, if the optical element is in a high temperature state due to heat generated by the optical element, the light emission efficiency of the optical element is significantly lowered. Therefore, the housing member is suitably formed of alumina ceramic, aluminum nitride ceramic or the like having good heat dissipation, or formed by plating these with a metal such as gold or copper as a heat dissipation material.

When the optical element is a light emitting element, the illuminance of light emitted from the light emitting element decreases as the irradiation distance increases. Further, in consideration of the use of the optical element in various places in the design of the module, compactness of the device is required. From such a viewpoint, the distance between the optical element and the window material for an optical element is preferably 0.5 mm or more, more preferably 1 mm or more, and preferably 10 mm or less, more preferably 8 mm or less.

When the optical element is housed inside the housing member, the optical element is sealed in the optical element package by a flip chip method. In this case, light is usually reflected and extracted by a reflector. The flip chip type light emitting element, without the window material for an optical element, exhibits the batwing light distribution as shown by the light distribution properties of Reference Example 1 in FIG. 7, in which the output right above the light emitting element is weaker than the output around the light emitting element. Due to the presence of the reflector, the light from the light emitting element is emitted to the outside of the optical element package as light having a light distribution angle. From the viewpoint of controlling the light distribution angle, the light emitting element is preferably an optical element that emits light having a light distribution angle of 150 degrees or less.

In addition to the optical element, other members such as a lead for electrical conduction between the optical element and the outside of the optical element package, and a reflector for improving light extraction efficiency can be provided inside the portion surrounded by the window material for an optical element and the housing member. A portion excluding the optical element and such other members may be in a vacuum state, a state of being filled with air or a gas including an inert gas such as nitrogen, or a state of being sealed with a solid sealing member such as a transparent rubber, an elastomer, or a resin. From the viewpoint of dissipation of heat generated by the optical element, the portion is preferably in a state of not being sealed with a solid sealing member, such as a vacuum state or a state of being filled with air or a gas including an inert gas such as nitrogen.

## EXAMPLES

Hereinafter, the present invention is more specifically described with reference to Examples, Comparative Examples, and Reference Examples, but the present invention is not limited to the following Examples.

## Example 1

A sliced synthetic quartz glass wafer substrate was lapped with a double-sided lapping machine that performs planetary motion to produce, by machining, a synthetic quartz glass wafer substrate having a thickness of 0.5 mm and having both main surfaces as rough surfaces. The obtained synthetic quartz glass wafer substrate was immersed in 10 wt% buffered hydrofluoric acid for 30 minutes to adjust the surface state of the substrate.

As for both the main surfaces as rough surfaces of the substrate, a dale void volume (Vvv) of a scale-limited surface having an areal material ratio of 10% and a peak material volume (Vmp) of a scale-limited surface having an areal material ratio of 80%, which are defined according to JIS B 0681-2: 2018, were measured using a white interferometer (Nexview manufactured by Zygo Corporation). The total value (Vvv + Vmp) was calculated, and as a result, it was $1.85 \times 10^4$ $\mu m^3$ for both the main surfaces. In addition, for both the main surfaces as rough surfaces of the substrate, the surface roughness (Ra) along an arbitrary straight line of 4 mm defined on the main surface was measured with a surface roughness measuring instrument (SURFCOM NEX manufactured by TOKYO SEIMITSU CO., LTD.), and the result was 0.45 $\mu m$ for both the main surfaces.

Next, a first layer, a second layer, and a third layer were formed on both the main surfaces as rough surfaces of the substrate in this order from the substrate side by a vacuum vapor deposition method to form an antireflection film composed of three thin films, thereby obtaining a window material for an optical element. The material, refractive index, and optical film thickness of the layers are shown in Table 1.

The obtained window material for an optical element was installed at a position of 4 mm from a window material of a commercially available surface mount optical element package (VPC164 manufactured by Nikkiso Co., Ltd.). In the surface mount optical element package, a 30 mW class UVC-LED chip having a central emission wavelength of 280 nm and a reflector are sealed with the window material inside a 3.5-mm square package carrier made of aluminum nitride, and the emitted light has a light distribution angle of 130 degrees. In this way, a light emitting device was formed.

The UVC-LED in the optical element package was turned on, and using a small goniophotometer (LEDGON manufactured by Instrument Systems, Inc.), as illustrated in FIG. 4, the window material 1 for an optical element, a commercially available surface mount optical element package 200, a goniometer 201, and a light receiver 202 were arranged, and the light distribution angle and the total light transmittance were measured. As a result, the light distribution angle was 80 degrees, and the total light transmittance was 85%. In addition, as illustrated in FIG. 7, the batwing light distribution was eliminated.

In addition, in a state where the UVC-LED in the optical element package was turned on, the light emitting device was allowed to stand for 2400 hours under a constant temperature and humidity environment of 85°C and 85% RH, and then the total light transmittance was measured. As a result, the total light transmittance was not changed and was maintained at 85%. In addition, no defect such as peeling was observed in the antireflection film.

Example 2

A window material for an optical element was obtained in the same manner as in Example 1 except that the antireflection film was formed only on one of the main surfaces as rough surfaces of the substrate. A light emitting device was formed in the same manner as in Example 1, and the light distribution angle and the total light transmittance were measured. As a result, the light distribution angle was 80 degrees, and the total light transmittance was 82%.

Example 3

A sliced synthetic quartz glass wafer substrate was lapped with a double-sided lapping machine that performs planetary motion to produce, by machining, a synthetic quartz glass wafer substrate having a thickness of 0.5 mm and having both main surfaces as rough surfaces. Next, one of the main surfaces of the obtained substrate was mirror-finished using a polyurethane-based polishing cloth and a cerium oxide abrasive material by a single-sided polishing machine that performs planetary motion to produce a mirror surface. The obtained synthetic quartz glass wafer substrate was immersed in 10 wt% buffered hydrofluoric acid for 30 minutes to adjust the surface state of the substrate.

Next, Vvv and Vmp of one of the main surfaces as the rough surface of the substrate were measured in the same manner as in Example 1, and Vvv + Vmp was calculated. As a result, Vvv + Vmp was $2.01 \times 10^4$ $\mu m^3$. The surface roughness (Ra) of one of the main surfaces as the rough surface of the substrate was measured in the same manner as in Example 1. As a result, the surface roughness (Ra) was 0.40 $\mu m$.

Next, an antireflection film was formed in the same manner as in Example 1 to produce a window material for an optical element. A light emitting device was formed in the same manner as in Example 1, and the light distribution angle and the total light transmittance were measured. As a result, the light distribution angle was 81 degrees, and the total light transmittance was 81%.

Comparative Example 1

A window material for an optical element was obtained in the same manner as in Example 1 except that no antireflection film was formed on both the main surfaces. A light emitting device was formed in the same manner as in Example 1, and the light distribution angle and the total light transmittance were measured. As a result, the light distribution angle was 80 degrees, and the total light transmittance was 79%. In addition, as illustrated in FIG. 7, the batwing light distribution was eliminated.

Example 4

A window material for an optical element was obtained in the same manner as in Example 1 except that the layers in the antireflection films were as shown in Table 1. A light emitting device was formed in the same manner as in Example 1, and the light distribution angle and the total light transmittance were measured. As a result, the light distribution angle was 80 degrees, and the total light transmittance was 85%.

Example 5

A sliced synthetic quartz glass wafer substrate was lapped with a double-sided lapping machine that performs planetary motion to produce, by machining, a synthetic quartz glass wafer substrate having a thickness of 0.5 mm and having both main surfaces as rough surfaces. The obtained synthetic quartz glass wafer substrate was immersed in 10 wt% buffered hydrofluoric acid for 10 minutes to adjust the surface state of the substrate.

Next, Vvv and Vmp of both the main surfaces as the rough surfaces of the substrate were measured in the same manner as in Example 1, and Vvv + Vmp was calculated. As a result, Vvv + Vmp of both the main surfaces was $6.85 \times 10^4$ $\mu m^3$. The surface roughness (Ra) of both the main surfaces as the rough surfaces of the substrate was measured in the same manner as in Example 1. As a result, the surface roughness (Ra) of both the main surfaces was 0.47 $\mu m$.

Next, antireflection films were formed in the same manner as in Example 1 to produce a window material for an optical element. A light emitting device was formed in the same manner as in Example 1, and the light distribution angle and the total light transmittance were measured. As a result, the light distribution angle was 47 degrees, and the total light transmittance was 69%.

Comparative Example 2

A window material for an optical element was obtained in the same manner as in Example 5 except that no antireflection film was formed on both the main surfaces. A light emitting device was formed in the same manner as in Example 1, and the light distribution angle and the total light transmittance were measured. As a result, the light distribution angle was 48 degrees, and the total light transmittance was 66%.

Comparative Example 3

A sliced synthetic quartz glass wafer substrate was lapped with a double-sided lapping machine that performs planetary motion to produce, by machining, a synthetic quartz glass wafer substrate having a thickness of 0.5 mm and having both main surfaces as rough surfaces. Next, both the surfaces of the obtained substrate was mirror-finished using a polyurethane-based polishing cloth and a cerium oxide abrasive material by a single-sided polishing machine that performs planetary motion to produce mirror surfaces, thereby obtaining a window material for an optical element without an antireflection film.

Next, Vvv and Vmp of both the main surfaces as the mirror surfaces of the substrate were measured in the same manner as in Example 1, and Vvv + Vmp was calculated. As a result, Vvv + Vmp of both the main surfaces was $1.55 \times 10^2$ $\mu m^3$. The surface roughness (Ra) of both the main surfaces as the mirror surfaces of the substrate was measured with an atomic force microscope (AFM). As a result, the surface roughness (Ra) of both the main surfaces was 0.22 nm.

A light emitting device was formed in the same manner as in Example 1, and the light distribution angle and the total light transmittance were measured. As a result, the light distribution angle did not change and was 130 degrees, and the total light transmittance was 92%, which is a theoretical transmittance obtained from a synthetic quartz glass substrate having mirror surfaces on both sides.

Table 1

|  |  | Material | Refractive index | Optical film thickness |
|---|---|---|---|---|
| Examples 1 to 3 and 5 to 7 | Third layer | SiO$_2$ | 1.42 | 0.24λ |
|  | Second layer | HfO$_2$ | 2.20 | 0.50λ |
|  | First layer | Al$_2$O$_3$ | 1.62 | 0.25λ |

(continued)

|  | | Material | Refractive index | Optical film thickness |
|---|---|---|---|---|
| Example 4 | Third layer | $MgF_2$ | 1.41 | $0.26\lambda$ |
|  | Second layer | $HfO_2$ | 2.20 | $0.49\lambda$ |
|  | First layer | $Al_2O_3$ | 1.62 | $0.27\lambda$ |

Reference Example 1

A light emitting device was formed only with a commercially available surface mount optical element package (VPC164 manufactured by Nikkiso Co., Ltd.). In the surface mount optical element package, a 30 mW class UVC-LED chip having a central emission wavelength of 280 nm and a reflector are sealed with a window material inside a 3.5-mm square package carrier made of aluminum nitride, and the emitted light has a light distribution angle of 130 degrees.

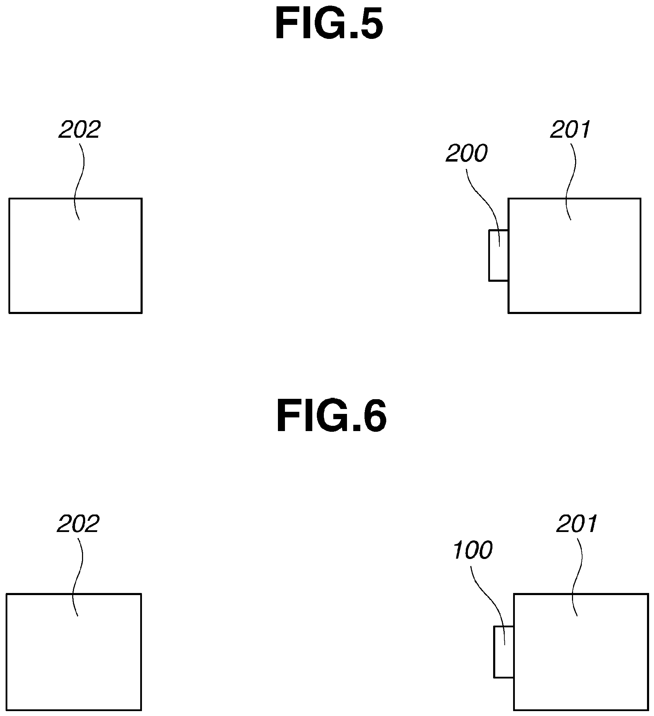

The UVC-LED in the optical element package was turned on, and using a small goniophotometer (LEDGON manufactured by Instrument Systems, Inc.), as illustrated in FIG. 5, a commercially available surface mount optical element package 200, a goniometer 201, and a light receiver 202 were arranged, and the light distribution angle and the total light transmittance were measured. As a result, the light distribution angle was 130 degrees. In addition, as illustrated in FIG. 7, the batwing light distribution was observed.

Example 6

A synthetic quartz glass wafer substrate obtained by the same method as in Example 1 was cut into a 3.5 mm square to form a synthetic quartz glass substrate, and the substrate was immersed in 10 wt% buffered hydrofluoric acid for 30 minutes to adjust the surface state of the substrate. Next, antireflection films were formed in the same manner as in Example 1 to produce a window material for an optical element.

Next, an adhesive agent layer having a width of 0.25 mm was applied by screen printing to an outer peripheral edge part of one main surface of the obtained window material for an optical element, the outer peripheral edge part being a part coming into contact with a housing member, to form a lid for an optical element package. For the adhesive agent layer, a metal-based adhesive agent containing bismuth, tin, indium, and silver was used.

In a housing member having a gold-plated part coming into contact with the 3.5-mm square lid for an optical element package, a 30 mW class UVC-LED chip that emits light having a light distribution angle of 120 degrees and has a central emission wavelength of 280 nm and a reflector were housed, and the obtained lid for an optical element package was bonded to the housing member with the adhesive agent layer and the components were sealed to obtain a surface mount optical element package.

The UVC-LED in the optical element package was turned on, and using a small goniophotometer (LEDGON manufactured by Instrument Systems, Inc.), as illustrated in FIG. 6, a surface mount optical element package 100, a goniometer 201, and a light receiver 202 were arranged, and the light distribution angle and the total light transmittance were measured. As a result, the light distribution angle was 80 degrees, and the total light transmittance was 93%.

Example 7

A synthetic quartz glass wafer substrate obtained by the same method as in Example 1 was cut into a 3.5 mm square to form a synthetic quartz glass substrate, and the substrate was immersed in 10 wt% buffered hydrofluoric acid for 30 minutes to adjust the surface state of the substrate. Next, antireflection films were formed in the same manner as in Example 1 to produce a window material for an optical element.

Next, an adhesive agent layer having a width of 0.3 mm was applied using a dispenser to an outer peripheral edge part of one main surface of the obtained window material for an optical element, the outer peripheral edge part being a part coming into contact with a housing member, to form a lid for an optical element package. For the adhesive agent layer, a silicone resin-based adhesive agent (KER-3000-M2 manufactured by Shin-Etsu Chemical Co., Ltd.) was used.

In a housing member having a gold-plated part coming into contact with the 3.5-mm square lid for an optical element package, a 30 mW class UVC-LED chip that emits light having a light distribution angle of 120 degrees and has a central emission wavelength of 280 nm and a reflector were housed, and the obtained lid for an optical element package was bonded to the housing member with the adhesive agent layer and the components were sealed to obtain a surface mount optical element package.

The UVC-LED in the optical element package was turned on, and using a small goniophotometer (LEDGON manufactured by Instrument Systems, Inc.), as illustrated in FIG. 6, a surface mount optical element package 100, a goniometer 201, and a light receiver 202 were arranged, and the light distribution angle and the total light transmittance were measured. As a result, the light distribution angle was 80 degrees, and the total light transmittance was 93%.

**Claims**

1. A window material for an optical element, comprising: a synthetic quartz glass substrate having a flat plate shape and having main surfaces through which light is transmitted, at least one of the main surfaces being a rough surface; and an antireflection film formed on the at least one main surface of the synthetic quartz glass substrate, the main surface being the rough surface.

2. The window material for an optical element according to claim 1, wherein in the at least one main surface as the rough surface, a total value of a dale void volume (Vvv) of a scale-limited surface having an areal material ratio of 10% and a peak material volume (Vmp) of a scale-limited surface having an areal material ratio of 80% is $1.7 \times 10^4$ $\mu m^3$ or more, the areal material ratios defined according to JIS B 0681-2: 2018.

3. The window material for an optical element according to claim 1 or 2, wherein the at least one main surface as the rough surface has a surface roughness (Ra) of 0.1 to 0.5 $\mu m$, the surface roughness (Ra) being a surface roughness along an arbitrary straight line of 4 mm defined on the main surface as the rough surface.

4. The window material for an optical element according to any one of claims 1 to 3, which is a window material for a light emitting element, the light emitting element being an ultraviolet LED element that emits light having a wavelength of 255 to 300 nm.

5. The window material for an optical element according to any one of claims 1 to 4, wherein the antireflection film is formed of a metal compound selected from a metal oxide and a metal fluoride.

6. The window material for an optical element according to any one of claims 1 to 5, wherein the antireflection film includes three layers of a first layer, a second layer, and a third layer in this order from a side of the synthetic quartz glass substrate.

7. The window material for an optical element according to claim 6, wherein the first layer is formed of a thin film containing $Al_2O_3$, the second layer is formed of a thin film containing $HfO_2$, and the third layer is formed of a thin film containing $MgF_2$ or $SiO_2$.

8. The window material for an optical element according to claim 6 or 7, wherein optical film thicknesses of the first layer, the second layer, and the third layer of the antireflection film are in a range mentioned below relative to a central emission wavelength of the light emitting element:

$$0.20\lambda \leq n_1d_1 \leq 0.30\lambda,$$

$$0.45\lambda \leq n_2d_2 \leq 0.55\lambda,$$

and

$$0.20\lambda \leq n_3d_3 \leq 0.30\lambda$$

wherein $n_1$, $n_2$, and $n_3$ respectively represent refractive indices of the first layer, the second layer, and the third layer, $d_1$, $d_2$, and $d_3$ respectively represent physical film thicknesses of the first layer, the second layer, and the third layer, $n_1d_1$, $n_2d_2$, and $n_3d_3$ respectively represent the optical film thicknesses of the first layer, the second layer, and the third layer, and $\lambda$ represents the central emission wavelength of the light emitting element.

9. The window material for an optical element according to any one of claims 1 to 8, which is a window material for a light emitting element, wherein the light emitting element emits light having a light distribution angle of 150 degrees or less.

10. A lid for an optical element package, comprising: the window material for an optical element according to any one of claims 1 to 9; and an adhesive agent layer laminated on a part of one of the main surfaces of the synthetic quartz glass substrate of the window material for an optical element.

11. The lid for an optical element package according to claim 10, wherein an adhesive agent that constitutes the adhesive agent layer is a resin-based adhesive agent or a metal-based adhesive agent.

12. The lid for an optical element package according to claim 10 or 11, wherein the adhesive agent layer is in a semi-cured state (B-stage).

13. An optical element package comprising: an optical element; a housing member in which the optical element is installed; the window material for an optical element according to any one of claims 1 to 8; and an adhesive layer, wherein
the window material for an optical element is provided at a position through which the light passes; and the optical element is housed in the housing member, and the housing member and the window material for an optical element are joined to each other with the adhesive layer interposed therebetween to seal the optical element.

14. The optical element package according to claim 13, wherein the optical element is a light emitting element, and the light emitting element is an ultraviolet LED element that emits light having a wavelength of 255 to 300 nm.

15. The optical element package according to claim 13 or 14, wherein the optical element is a light emitting element, and the light emitting element emits light having a light distribution angle of 150 degrees or less.

# FIG.1

# FIG.2

# FIG.3

# FIG.4

# FIG.5

202

200  201

# FIG.6

202

100  201

# FIG.7

Europäisches
Patentamt

European
Patent Office

Office européen
des brevets

# EUROPEAN SEARCH REPORT

Application Number

EP 24 15 1454

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 882 672 A1 (SHINETSU CHEMICAL CO [JP]) 22 September 2021 (2021-09-22) | 1,4-15 | INV.<br>C03C17/34 |
| Y | * paragraphs [0009], [0067] – [0071], [0076] – [0083]; claims; figures 1,2 * | 1-15 | C03C15/00<br>G02B1/115<br>G02B5/02 |
| X | ----- US 2022/315482 A1 (TANIBE KENJI [JP] ET AL) 6 October 2022 (2022-10-06) * paragraphs [0014] – [0020], [0063]; claims; figures 14,15,20-22 * | 1-4,9 | H01L33/00<br>C04B37/00 |
| X | ----- WO 2012/032162 A1 (FRAUNHOFER GES FORSCHUNG [DE]; UNIV SCHILLER JENA [DE] ET AL.) 15 March 2012 (2012-03-15) * page 5, lines 1-3,21-31; claims; figures 1,2 * | 1-4,9 | |
| Y | ----- EP 3 279 953 B1 (SHINETSU CHEMICAL CO [JP]) 12 May 2021 (2021-05-12) * paragraphs [0013], [0028], [0047] – [0051]; claims; figure 1; examples 1-5 * | 1-15 | |
| A | ----- EP 4 002 499 A1 (SHINETSU CHEMICAL CO [JP]) 25 May 2022 (2022-05-25) * paragraphs [0001], [0006], [0007]; claims; figure 1 * ----- | 1-15 | TECHNICAL FIELDS SEARCHED (IPC)<br><br>C03C<br>H01L<br>G02B<br>C04B |

The present search report has been drawn up for all claims

| Place of search | Date of completion of the search | Examiner |
|---|---|---|
| Munich | 13 May 2024 | Zandonà, Alessio |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
.......................................................................
& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 15 1454

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2024

| Patent document cited in search report | | | Publication date | Patent family member(s) | | | Publication date |
|---|---|---|---|---|---|---|---|
| EP 3882672 | | A1 | 22-09-2021 | CN | 113497172 | A | 12-10-2021 |
| | | | | EP | 3882672 | A1 | 22-09-2021 |
| | | | | JP | 7136151 | B2 | 13-09-2022 |
| | | | | JP | 2021148902 | A | 27-09-2021 |
| | | | | KR | 20210117182 | A | 28-09-2021 |
| | | | | TW | 202204283 | A | 01-02-2022 |
| | | | | US | 2021293994 | A1 | 23-09-2021 |
| US 2022315482 | | A1 | 06-10-2022 | JP | 6901189 | B1 | 14-07-2021 |
| | | | | JP | WO2021137274 | A1 | 08-07-2021 |
| | | | | US | 2022315482 | A1 | 06-10-2022 |
| | | | | WO | 2021137274 | A1 | 08-07-2021 |
| WO 2012032162 | | A1 | 15-03-2012 | NONE | | | |
| EP 3279953 | | B1 | 12-05-2021 | CN | 107689412 | A | 13-02-2018 |
| | | | | DK | 3279953 | T3 | 05-07-2021 |
| | | | | EP | 3279953 | A1 | 07-02-2018 |
| | | | | JP | 6623968 | B2 | 25-12-2019 |
| | | | | JP | 2018022760 | A | 08-02-2018 |
| | | | | KR | 20180015581 | A | 13-02-2018 |
| | | | | TW | 201818569 | A | 16-05-2018 |
| | | | | US | 2018040778 | A1 | 08-02-2018 |
| EP 4002499 | | A1 | 25-05-2022 | CN | 114497329 | A | 13-05-2022 |
| | | | | EP | 4002499 | A1 | 25-05-2022 |
| | | | | JP | 2022077578 | A | 24-05-2022 |
| | | | | KR | 20220064908 | A | 19-05-2022 |
| | | | | TW | 202232787 | A | 16-08-2022 |
| | | | | US | 2022149247 | A1 | 12-05-2022 |

EPO FORM P0459

For more details about this annex : see Official Journal of the European Patent Office, No. 12/82

**EP 4 403 532 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001013304 A

- JP 2013226473 A